# EUROPEAN PATENT APPLICATION

(11) **EP 3 745 474 A1**
(43) Date of publication of application: **02.12.2020**
(21) Application number: 19177109.6
(22) Date of filing: 28.05.2019
(51) Int. Cl.: H01L 33/20, H01L 33/44

(54) **OPTOELECTRONIC DEVICE AND METHOD FOR MANUFACTURING AN OPTOE-LECTRONIC DEVICE**

(71) Applicant: OSRAM Opto Semiconductors GmbH, 93055 Regensburg (DE)
(72) Inventor: BEHRINGER, Martin, 93049 Regensburg (DE); LORENZO, Zini, 93049 Regensburg (DE); WANG, Xue, 93047 Regensburg (DE)
(74) Representative: Zacco Patent- & Rechtsanwälte

(57) **Abstract**

An optoelectronic device (10) comprises a carrier layer (11) and a p-n diode layer (12) arranged over the carrier layer (11) and provided in a mesa structure, wherein the p-n diode layer (12) comprises a main surface (16) and side walls (18, 19) with the main surface (16) facing the carrier layer (11), and wherein at least a portion of at least one of the side walls (18, 19) of the p-n diode layer (12) forms an angle with the main surface (16) in the range from 88° to 92°.

## Description

The invention concerns an optoelectronic device and a method for manufacturing an optoelectronic device.

Leakage currents in optoelectronic devices, such as light emitting diodes (LED), can reduce the light output at low currents. In particular, the linear relationship between applied current and light output that can be measured at high currents may not be valid for low currents. This effect may be caused by nonradiative recombination of charge carriers that do not contribute to the light generation.

It is an underlying object of the invention to provide an optoelectronic device that allows high light efficiency even at low currents. It is further an object of the invention to provide a method for manufacturing the optoelectronic device.

An object underlying the invention is satisfied by an optoelectronic device having the features of the independent claim 1. Further, an object underlying the invention is satisfied by a method for manufacturing an optoelectronic device having the features of independent claim 6. Advantageous further developments and aspects of the invention are set forth in the dependent claims.

In a first aspect of the instant application an optoelectronic device, in particular a light emitting optoelectronic device, is provided. The optoelectronic device comprises a carrier layer and a p-n diode layer arranged over the carrier layer, in particular, deposited on the carrier layer.

The p-n diode layer is a semiconductor diode made by joining a p-type or p-doped semiconducting layer to an n-type or n-doped semiconducting layer. The p-n diode layer can be used for emitting light and/or detecting light. The p-n diode layer may comprise an active region or active layer that emits and/or detects light.

The light emitted and/or detected by the optoelectronic device may be from the visible, ultraviolet (UV) and/or infrared spectrum.

The p-n diode layer may include a compound semiconductor having a bandgap corresponding to a specific region in the light spectrum. The p-n diode layer may be a stack of multiple semiconductor layers, each with a different composition and doping concentration. For example, the p-n diode layer may include one or more layers based on III-V or II-VI semiconductor materials. The p-n diode layer may be an epitaxial layer made by epitaxial growth.

The carrier layer may include any suitable carrier or substrate material such as, but not limited to, SiC, Ge, GaAS, GaN and sapphire (Al₂O₃). The p-n diode layer may be deposited or bonded directly onto the carrier layer or, alternatively, one or more additional layers, for example, made of Au, SiO₂ or other suitable materials, may be arranged between the carrier layer and the p-n diode layer. The carrier layer may be a substrate layer on that the p-n diode layer has grown, for example, by epitaxial growth. Alternatively, the p-n diode layer has been grown on another substrate and, afterwards, has been bonded to the carrier layer, in particular, before the mesa etching described below.

The p-n diode layer has a main surface, in particular a first main surface, facing the carrier layer. The p-n diode layer may have a second main surface opposite to the first main surface. Further, the p-n diode layer comprises side walls or side surfaces. The side walls may be arranged on the edges of the p-n diode layer or inside the p-n diode layer. The side walls may extend from the first main surface to the second main surface. One or multiple or all of the side walls may be tapered side walls.

The p-n diode layer is provided in a mesa structure, thus has the shape of a mesa. At least a portion of at least one of the side walls of the p-n diode layer forms an angle α with the main surface of the p-n diode layer. It may be provided that at least 50% or 60% or 70% or 80% or 90% of the surface of the at least one side wall form the angle α with the main surface of the p-n diode layer. Further, it may be provided that multiple side walls or all side walls of the p-n diode layer each form the angle α with the main surface of the p-n diode layer. In particular, at least 50% or 60% or 70% or 80% or 90% of the surfaces of the multiple side walls or of all side walls of the p-n diode layer form the angle α with the main surface of the p-n diode layer.

The angle α is in the range from 88° to 92°. In particular, the angle α is in the range from 88.5° to 90.5°. In one embodiment, the value of α = 90° is excluded from the aforementioned ranges. In a further embodiment, the angle α is equal to or greater than 88° and less than 90°. In a further embodiment, the angle α is equal to or greater than 88.5° and less than 90°. In a further embodiment, the angle α is greater than 90° and equal to or less than 92°. In yet a further embodiment, the angle α is greater than 90° and equal to or less than 90.5°.

It was found that micro prisms can cause a portion of the leakage current in optoelectronic devices. In addition, it was found that the leakage current correlates with the length of the line along which the p-n diode layer and thus the active layer is severed or etched. Due to the steep side walls of the p-n diode layer proposed herein only a small fraction of the semiconductor material of the active region of the p-n diode layer is damaged. This leads to only small leakage currents and thus increased light efficiency. Even at low currents the optoelectronic device can be operated in a linear range. This allows to realize the optoelectronic device as a semiconductor chip having small lateral dimensions. Further, the maximum efficiency, i.e., the current range having maximum efficiency, can be reached at lower currents when compared to conventional optoelectronic devices. Thus, the optoelectronic device described herein can be operated in a range allowing higher total efficiency.

The p-n diode layer may comprises an n-doped layer, a p-doped layer and an active layer, wherein the active layer is arranged between the n-doped layer and the p-doped layer. The active layer emits and/or detects light. The n-doped layer, the p-doped layer and the active layer are made of semiconductor materials with suitable doping concentrations.

In addition, the p-n diode layer may comprise one or more further layers, in particular further semiconductor layers. One or more metallization layers may be arranged on top of the p-n diode layer and/or between the p-n diode layer and the carrier layer.

One or more electrically insulating layers, for example, made of silicon nitride and/or silicon oxide, may be deposited on the one or more tapered side walls of the p-n diode layer. The one or more electrically insulating layers may only cover the tapered side walls or, alternatively, cover other surfaces of the p-n diode layer and/or the carrier layer as well. The electrically insulating layers passivate the tapered side walls. The optoelectronic device may be a light emitting diode (LED). In particular, the optoelectronic device may be a thin film (TF) LED and/or a micro LED (µLED). A µLED has a thin carrier layer, which allows to reduce the lateral dimensions of the µLED.

In a second aspect of the instant application a method for manufacturing an optoelectronic device, in particular a light emitting optoelectronic device, is provided.

The method comprises providing a carrier layer and arranging a p-n diode layer over the carrier layer, in particular, depositing the p-n diode layer on the carrier layer or bonding the p-n diode layer to the carrier layer. A main surface of the deposited p-n diode layer faces the carrier layer. A mesa etching process is then performed to define a mesa structure in the p-n diode layer. After the etching step, at least a portion of at least one of the side walls of the p-n diode layer has a tapered shape. Further, at least a portion of at least one of the side walls of the etched p-n diode layer forms an angle α with the main surface in the range from 88° to 92°.

The method according to the second aspect may comprise the embodiments disclosed above in connection with the optoelectronic device according to the first aspect.

Dry chemical etching may be used for etching the p-n diode layer to define the mesa structure. Prior to the etching a photoresist layer can be formed over the p-n diode layer and the photoresist layer is patterned. The p-n diode layer is then only etched at those areas that are exposed from the photoresist mask. For example, the etching is carried out by using a chemical ionization (CI) plasma.

After the mesa etching process, a damage etching process may be performed in order to remove damaged material from the side walls of the p-n diode layer. This material has been damaged during the mesa etching process. The damage etching improves the low current behavior of the optoelectronic device and possibly reduces the nonradiative recombination of charge carriers. Wet chemical etching may be used for the damage etching. Alternatively, a CI plasma having a large chemical proportion and only a small proportion of physical etching may be used.

The one or more electrically insulating layers described above may be deposited on the side walls of the p-n diode layer after the damage etching step. Alternatively, the one or more electrically insulating layers may be deposited without performing the damage etching process.

The following description of figures may further illustrate and explain exemplary embodiments. Components that are functionally identical or have an identical effect are denoted by identical references. Identical or effectively identical components might be described only with respect to the figures where they occur first. Their description is not necessarily repeated in successive figures. There are shown in the drawings:
- Fig. 1: a schematic representation of an exemplary embodiment of an optoelectronic device;
- Fig. 2: a schematic representation of a further exemplary embodiment of an optoelectronic device; and
- Fig. 3: a schematic representation of an exemplary embodiment of a method for manufacturing an optoelectronic device.

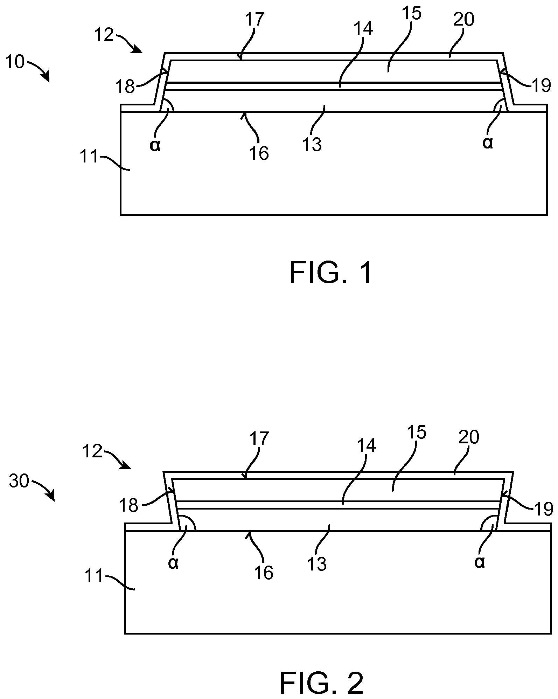

Fig. 1 illustrates an optoelectronic device embodied as an LED 10 in cross section. The LED 10 includes a carrier layer 11 and a p-n diode layer 12 arranged over the carrier layer 11. Other layers, such as metallization layers and/or electrically insulating layers, may be arranged between the carrier layer 11 and the p-n diode layer 12.

The carrier layer 11 is made of a suitable material, for example, SiC, Ge, GaAS, GaN and sapphire (Al₂O₃).

The p-n diode layer 12 includes a p-doped layer 13, an active layer 14 and an n-doped layer 15, which are deposited in the given order on the carrier layer 11. The layers 13 to 15 are made of semiconductor materials with suitable doping concentrations.

The p-n diode layer 12 has a first main surface 16 and a second main surface 17 opposite to the first main surface 16. A number of side walls extend from the first main surface 16 to the second main surface 17. In Fig. 1 side walls 18 and 19 of the p-n diode layer 12 are shown.

The p-n diode layer 12 has the shape of a mesa, which means that the side walls 18, 19 are tilted relative to the first main surface 16 of the p-n diode layer 12. Each of the side walls 18, 19 forms an angle α with the first main surface 16.

The angle α is in the range from 88° to 92° and, in particular, in the range from 88.5° to 90.5°. Fig. 1 shows an embodiment with an angle α less than 90°.

An electrically insulating layer 20 is deposited on the side walls 18, 19 and also the second main surface 17 of the p-n diode layer 20 and the exposed surface of the carrier layer 11. The electrically insulating layer 20 is made of silicon nitride, silicon oxide or any other suitable material.

Fig. 2 illustrates an optoelectronic device embodied as an LED 30 in cross section. The LED 30 is similar to the LED 10 shown in Fig. 1. The difference between the LED 30 and the LED 10 is that the angle α of the LED 30 is greater than 90°.

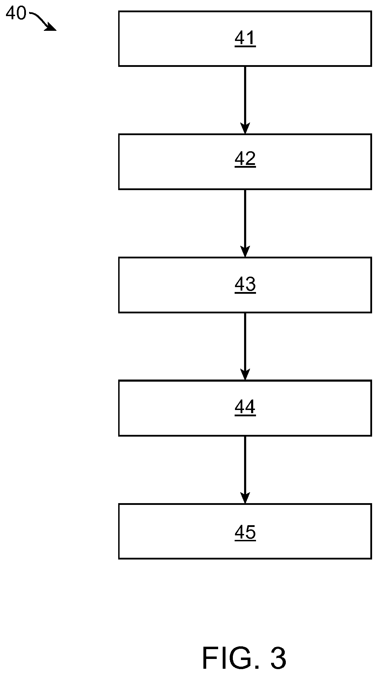

Fig. 3 illustrates a method 40 for manufacturing the LEDs 10 and 30.

In step 41 of the method 40, the carrier layer 11 is provided.

In step 42, the p-n diode layer 12 comprising the p-doped layer 13, the active layer 14 and the n-doped layer 15 is arranged over the carrier layer 11. For example, the p-n diode layer 12 is deposited on the carrier layer 11 by epitaxial growth.

In step 43, a photoresist layer is formed over the p-n diode layer 12 and the photoresist layer is patterned. Afterwards a mesa etching step is carried out, for example, by using a CI plasma, in order to etch the steep side walls 18, 19 of the p-n diode layer 12. The photoresist layer is then lifted off.

In step 44, a damage etching step is performed in order to remove damaged material from the side walls 18, 19 of the p-n diode layer 12.

In step 45, the insulating layer 20 is deposited by any suitable method, for example, by sputtering or vapor deposition.

The description with the aid of the exemplary embodiments does not limit the invention thereto. Rather, the invention comprises any new feature and any combination of features, which in particular includes any combination of features in the patent claims, even if this feature or this combination is not itself explicitly stated in the patent claims or exemplary embodiments.

### LIST OF REFERENCE SIGNS

- 10: LED
- 11: carrier layer
- 12: p-n diode layer
- 13: p-doped layer
- 14: active layer
- 15: n-doped layer
- 16: first main surface
- 17: second main surface
- 18: side wall
- 19: side wall
- 20: insulating layer
- 30: LED
- 40: method
- 41: step
- 42: step
- 43: step
- 44: step
- 45: step

## Claims

1. An optoelectronic device (10, 30), comprising:
a carrier layer (11), and
a p-n diode layer (12) arranged over the carrier layer (11) and provided in a mesa structure,
wherein the p-n diode layer (12) comprises a main surface (16) and side walls (18, 19) with the main surface (16) facing the carrier layer (11), and
wherein at least a portion of at least one of the side walls (18, 19) of the p-n diode layer (12) forms an angle with the main surface (16) in the range from 88° to 92°.

2. The optoelectronic device (10, 30) as claimed in claim 1, wherein the portion of the at least one of the side walls (18, 19) of the p-n diode layer (12) forms an angle with the main surface (16) in the range from 88.5° to 90.5°.

3. The optoelectronic device (10, 30) as claimed in claim 1 or 2, wherein the p-n diode layer (12) comprises an n-doped layer (15), a p-doped layer (13) and an active layer (14) arranged between the n-doped layer (15) and the p-doped layer (13).

4. The optoelectronic device (10, 30) as claimed in one of the preceding claims, wherein an electrically insulating layer (20) is deposited on the at least one of the side walls (18, 19) of the p-n diode layer (12).

5. The optoelectronic device (10, 30) as claimed in one of the preceding claims, wherein the optoelectronic device is a light emitting diode (10, 30).

6. A method for manufacturing an optoelectronic device (10, 30), comprising:
arranging a p-n diode layer (12) over a carrier layer (11), and
etching the p-n diode layer (12) to define a mesa structure,
wherein the etched p-n diode layer (12) comprises a main surface (16) and side walls (18, 19) with the main surface (16) facing the carrier layer (11), and
wherein at least a portion of at least one of the side walls (18, 19) of the etched p-n diode layer (12) forms an angle with the main surface (16) in the range from 88° to 92°.

7. The method as claimed in claim 6, further comprising damage etching the at least one side wall (18, 19) of the p-n diode layer (12).

8. The method as claimed in claim 6 or 7, wherein the portion of the at least one of the side walls (18, 19) of the etched p-n diode layer (12) forms an angle with the main surface (16) in the range from 88.5° to 90.5°.

9. The method as claimed in one of claims 6 to 8, wherein depositing the p-n diode layer (12) comprises depositing a p-doped layer (13), an active layer (14) and an n-doped layer (15).

10. The method as claimed in one of claims 6 to 9, further comprising depositing an electrically insulating layer (20) on the at least one of the side walls (18, 19) of the etched p-n diode layer (12).

11. The method as claimed in one of claims 6 to 10, wherein the optoelectronic device is a light emitting diode (10, 30) .

12. The method as claimed in one of claims 6 to 11, wherein dry chemical etching is used for etching the p-n diode layer (12) to define the mesa structure.
